# FASCICULE DE BREVET EUROPEEN

(11) **EP 3 555 709 B1**
(45) Date de publication et mention de la délivrance du brevet: **07.04.2021**
(21) Numéro de dépôt: 17811341.1
(22) Date de dépôt: 14.12.2017
(51) Int. Cl.: G04B 37/22, G04B 19/12, G04D 3/00, G04B 45/00, C23C 14/14, C23C 14/02, C23C 14/04, C23C 14/58

(54) **ELEMENT D'HABILLAGE OU CADRAN D'HORLOGERIE EN MATERIAU NON CONDUCTEUR**
VERKLEIDUNGSELEMENT ODER ZIFFERBLATT EINER UHR AUS NICHT-LEITENDEM MATERIAL
TRIM ELEMENT OR TIMEPIECE DIAL MADE OF NON-CONDUCTIVE MATERIAL

(30) Priorité: 16.12.2016 EP 16204645
(43) Date de publication de la demande: 23.10.2019
(73) Titulaire: Rubattel et Weyermann S.A., 2300 La Chaux-de-Fonds (CH)
(72) Inventeur: LARRIÈRE, Mehdy, 25130 Villers-le-Lac (FR); TIXIER, Benjamin, 2000 Neuchâtel (CH)
(74) Mandataire: ICB SA
(86) Numéro de dépôt international: PCT/EP2017/082767
(87) Numéro de publication internationale: WO 2018/109065

(56) Documents cités:
- EP-A1- 2 628 607
- EP-A1- 2 856 903
- EP-A1- 3 067 220
- EP-A2- 2 965 855
- CH-A2- 710 494
- CH-A2- 710 716
- JP-A- H05 156 425

## Description

### Domaine de l'invention

L'invention concerne un procédé de fabrication d'un élément d'habillage ou d'un cadran d'horlogerie en matériau non conducteur, où on effectue au moins une fois un cycle élémentaire comportant, dans cet ordre, les étapes suivantes :
- on réalise une embase en un substrat en matériau non conducteur, ou en céramique ou en verre ou en saphir ou en matériau au moins partiellement amorphe,
- on recouvre par voie sèche ladite embase d'au moins une première couche de protection métallique sacrificielle ;
- on effectue la gravure d'un décor, avec une profondeur au moins égale à l'épaisseur locale de ladite première couche de protection métallique sacrificielle, au moyen d'un laser à impulsion ultracourte type picolaser ou femtolaser
- on recouvre par voie sèche ledit décor et la partie restante de ladite première couche de protection métallique sacrificielle, avec au moins une deuxième couche de traitement décoratif métallique ou/et coloré ;
- on élimine par voie chimique chaque dite première couche de protection métallique sacrificielle.

L'invention concerne le domaine des composants d'habillage ou d'affichage pour l'horlogerie, et le domaine de la bijouterie.

### Arrière-plan de l'invention

Pour la fabrication de composants bicolores, on connaît un procédé consistant à :
- poser une couche de protection sacrificielle (résine photosensible, vernis, adhésif, film polymère) sur l'ensemble de la surface d'une ébauche ;
- attaquer sélectivement la couche de protection, avec gravure éventuelle du substrat ;
- effectuer un traitement décoratif (galvanoplastie, dépôt sous vide, vernis, laque) ;
- retirer la couche de protection (attaque chimique, dissolution, bombardement ionique, action mécanique).

Hors utilisation de résine photosensible, la définition des contours n'est pas très bonne.

De plus, le matériau de la couche de protection sacrificielle peut présenter un phénomène de dégazage lors d'un passage sous vide ultérieur, notamment pour effectuer le traitement décoratif par métallisation.

Le document JP H05 156425 A au nom de SEIKO EPSON Corp. décrit la formation d'une lettre en creux, ou plus généralement d'un motif, recouvert d'un film coloré, sur la surface d'un matériau de base tel qu'un alliage dur fritté, un alliage de platine ou d'or blanc, de céramique, par un procédé de formation de film sec. La surface du matériau est revêtue d'un film coloré en tant que première couche, un motif en creux ayant une profondeur supérieure à l'épaisseur de la première couche est formé sur la partie concernée par usinage par faisceau laser, le film coloré ayant une composition différente de celle de la première couche est appliqué en tant que deuxième couche par un procédé de formation de film sec, puis les première et deuxième couches, hors de la zone comportant le motif, sont évacuées.

Le document EP 3 067 220 A1 au nom de ROLEX décrit un procédé de décoration d'un élément horloger, avec un gravage profond d'une surface à décorer de l'élément par un laser femtoseconde; et une structuration de surface de cette surface à décorer de l'élément horloger, ces deux décorations étant au moins partiellement superposées l'une à l'autre.

### Résumé de l'invention

L'invention se propose de mettre au point un procédé de fabrication d'un élément d'habillage ou d'un cadran d'horlogerie en matériau non conducteur, notamment en céramique ou similaire, permettant l'obtention de décors gravés métallisés et/ou colorés.

A cet effet, l'invention concerne un procédé selon la revendication 1.

Le mode opératoire proposé permet l'obtention de décors de définition élevée sur des substrats non conducteurs, tes que céramique, saphir, verre, ou similaire.

De plus, l'invention permet de s'affranchir de l'utilisation de couches de protection organique qui pourraient présenter du dégazage lors d'un passage sous vide ultérieur pour métallisation.

Enfin, la solution présentée ne nécessite pas l'acquisition de matériel de photolithographie onéreux (spin coater, aligneur de masque, salle jaune), et peut être réalisée avec des équipements usuels de gravure mécanique, ou plus particulièrement de gravure laser.

### Description sommaire des dessins

D'autres caractéristiques et avantages de l'invention apparaîtront à la lecture de la description détaillée qui va suivre, en référence aux dessins annexés, où :
- la figure 1 représente, de façon schématisée et en coupe, une séquence opératoire d'un cycle élémentaire du procédé selon l'invention, comportant la réalisation d'une embase, sa couverture avec une première couche de protection métallique sacrificielle, la gravure d'un décor, le dépôt d'une deuxième couche de traitement décoratif métallique ou/et coloré, et l'élimination de la première couche de protection métallique sacrificielle;
- la figure 2 représente, de façon similaire à la figure 1, la seule étape de gravure dans laquelle toutes les gravures atteignent le substrat de l'embase ;
- la figure 3 représente, de façon similaire à la figure 1, une étape d'arasement mécanique de la première couche de protection métallique sacrificielle, et de la deuxième couche de traitement décoratif, avant l'élimination de la première couche de protection métallique sacrificielle;
- la figure 4 représente, de façon similaire à la figure 3, une étape d'arasement mécanique de la deuxième couche de traitement décoratif, après l'élimination de la première couche de protection métallique sacrificielle;
- la figure 5 représente, de façon similaire à la figure 1, la seule étape de dépôt d'une première couche de protection métallique sacrificielle,, avec deux couches superposées de protection métallique sacrificielle ;
- la figure 6 représente, de façon similaire à la figure 1, la seule étape de dépôt d'une deuxième couche de traitement décoratif métallique ou/et coloré, avec deux couches superposées de traitement décoratif ;
- la figure 7 représente un détail de gravure comportant des gravures coniques, seules ou superposées, et des gravures de type pyramidal, seules ou superposées ;
- la figure 8 représente une montre comportant une lunette et un cadran en céramique réalisés et décorés par le procédé selon l'invention.

### Description détaillée des modes de réalisation préférés

L'invention concerne un procédé de fabrication d'un élément d'habillage ou d'un cadran d'horlogerie, ou encore d'un composant de bijouterie, en matériau non conducteur, notamment en céramique ou similaire, permettant l'obtention de décors gravés métallisés et/ou colorés.

Plus particulièrement, l'invention concerne un procédé de fabrication d'un élément d'habillage ou d'un cadran d'horlogerie en matériau non conducteur.

Selon l'invention, on effectue, au moins une fois, un cycle élémentaire comportant, dans cet ordre, les étapes suivantes :
- 10 : on réalise une embase 1 en un substrat en matériau non conducteur, ou en céramique ou en verre ou en saphir ou en matériau au moins partiellement amorphe,
- 20 : on recouvre par voie sèche cette embase 1 d'au moins une première couche 2 de protection métallique sacrificielle ;
- 30 : on effectue la gravure d'un décor 3, avec une profondeur au moins égale à l'épaisseur locale de la première couche 2 de protection métallique sacrificielle ;
- 40 : on recouvre par voie sèche ce décor 3 et la partie restante de la première couche 2 de protection métallique sacrificielle, avec au moins une deuxième couche 4 de traitement décoratif métallique ou/et coloré ;
- 50 : on élimine, notamment par voie chimique, chaque première couche 2 de protection métallique sacrificielle.

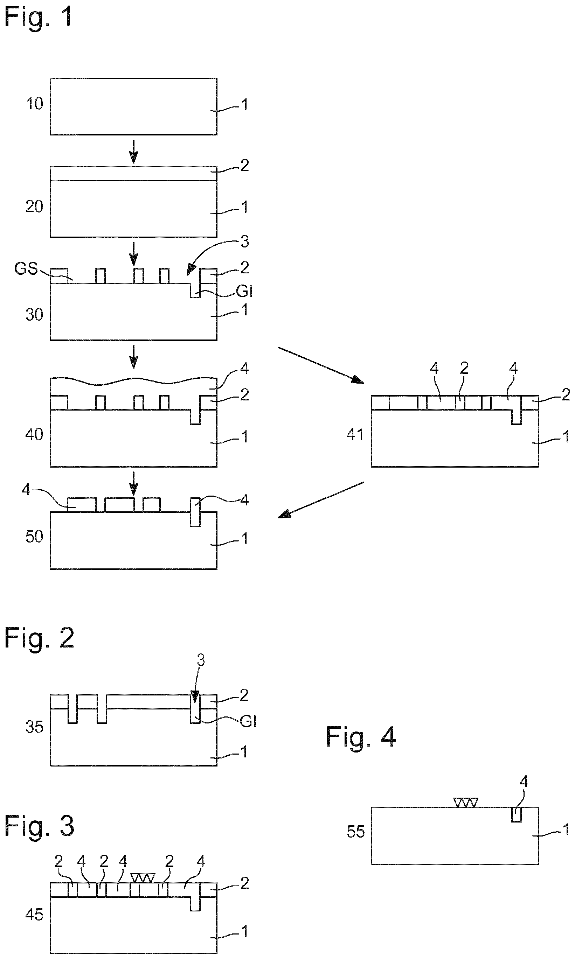

La figure 1 montre une variante 41, moins facile à réaliser, où l'opération 40 est modifiée par un dépôt de la deuxième couche de traitement décoratif au ras de la première couche 2 de protection métallique sacrificielle.

Pour une application particulière de réalisation de cadrans non conducteurs gravés métallisés et/ou colorés, une séquence opératoire avantageuse de l'invention comporte des paramètres particuliers :
- 20 : pose d'une couche de protection métallique sacrificielle : de préférence mais non limitativement aluminium, ou chrome, élaborée par voie sèche, plus particulièrement par dépôt PVD;
- 30 : gravure laser à impulsion ultracourte type picolaser ou femtolaser du décor, avec ablation sélective de la couche de protection métallique sacrificielle 2, et éventuellement gravure du substrat 1, dite gravure inférieure GI, tel que visible sur les figures;
- 40 : traitement décoratif métallique (or, rhodium, chrome, silicium, ou autre.) ou coloré (oxydes, nitrure et carbures métalliques ainsi que toute combinaison de leur empilement) élaboré par voie sèche, plus particulièrement PVD;
- 50 : retrait de la couche de protection par voie chimique (solution alcaline type NaOH pour aluminium, mais aussi éventuellement acide pour chrome, ou autre).

Le choix des matériaux est directement défini par les contraintes de la séquence opératoire.

En effet, la nature de la couche sacrificielle et celle de la couche décorative doivent être choisies de sorte à ce que :
- la solution de décapage permette le retrait de la couche de protection sans altérer le revêtement décoratif ;
- la couche de protection ne soit pas altérée lors de la gravure, notamment de la gravure au laser (à impulsion ultracourte type picolaser ou femtolaser), en d'autre endroit que dans la zone de gravure définie (altération possible à proximité de la gravure, projection de particules incandescentes) ;
- la couche de protection doit résister aux éventuels nettoyages intermédiaires.

Le choix, lors de l'étape 20, d'une couche de protection sacrificielle métallique évite un dégazage. En effet, cette protection métallique sacrificielle se compose d'un matériau inerte dans les conditions de pression (pouvant descendre jusqu'à P = 1.10⁻⁸ mbar) et de température (typiquement T ≤ 300°C) rencontrées lors du traitement décoratif de l'étape 40, contrairement aux laques/vernis utilisés dans l'art antérieur, qui présentent l'inconvénient, dans ces conditions, de dégazer et/ou se décomposer partiellement, ce qui pouvait perturber la qualité et/ou l'esthétique du traitement décoratif.

De préférence, avant d'effectuer l'étape 20 de recouvrement de l'embase 1 par au moins une première couche 2 de protection métallique sacrificielle, on effectue un nettoyage: lessiviel et/ou solvant, avec/sans ultrasons, avec/sans sollicitation mécanique, avec/sans température, pour assurer la propreté de la surface et ainsi assurer la bonne accroche de la protection métallique sacrificielle.

Dans une variante particulière, lors de l'opération de gravure 30 d'un décor 3, on effectue partout la gravure dans le substrat de l'embase 1, tel que visible sur la figure 2.

Naturellement il convient de nettoyer l'ébauche après l'opération de gravure, avant de procéder au deuxième dépôt de traitement décoratif, notamment par voie PVD. Ce nettoyage est classique (lessiviel et/ou solvant, avec/sans ultrasons, avec/sans sollicitation mécanique, avec/sans température), mais il ne doit pas altérer la protection métallique sacrificielle. En particulier, dans le cas où la protection métallique sacrificielle comporte de l'aluminium, il faut exclure des solutions de lavage ayant un pH trop basique.

Selon l'invention, avant ou après l'élimination (en étape 50) par voie chimique de chaque première couche 2 de protection métallique sacrificielle, on arase mécaniquement (dans une étape 55) le composé ainsi réalisé au niveau supérieur de l'embase 1.

Dans une variante particulière, après avoir recouvert par voie sèche 40 le décor 3 et la partie restante de la première couche 2 de protection métallique sacrificielle avec au moins une deuxième couche 4 de traitement décoratif métallique ou/et coloré, on arase mécaniquement 45 le composé ainsi réalisé au niveau supérieur de la première couche 2 de protection métallique sacrificielle.

Dans une autre variante particulière, avant l'élimination 50 par voie chimique de chaque première couche 2 de protection métallique sacrificielle, on arase mécaniquement 55 le composé ainsi réalisé au niveau supérieur de l'embase 1.

Dans une autre variante particulière, après l'élimination 50 par voie chimique de chaque première couche 2 de protection métallique sacrificielle, on arase mécaniquement 55 le composé ainsi réalisé au niveau supérieur de l'embase 1.

Dans une variante avantageuse, lors de l'étape 20 de recouvrement par voie sèche de l'embase 1 par au moins une première couche 2 de protection métallique sacrificielle, on effectue ce recouvrement par voie sèche par dépôt PVD sous vide.

Différentes méthodes peuvent convenir : évaporation sous vide, pulvérisation sous vide, PECVD, ou autres.

Dans une variante particulière, lors de l'étape 20 de recouvrement par voie sèche de l'embase 1 par au moins une première couche 2 de protection métallique sacrificielle, on effectue ce recouvrement avec une première épaisseur supérieure à 50 nanomètres.

Dans une variante avantageuse, lors de l'étape 40 de recouvrement par voie sèche du décor 3 et de la partie restante de la première couche 2 de protection métallique sacrificielle, par au moins une deuxième couche 4 de traitement décoratif métallique ou/et coloré, on effectue ce recouvrement par voie sèche par dépôt PVD sous vide.

Différentes méthodes peuvent convenir : évaporation sous vide, pulvérisation sous vide, CVD, ALD ou autres.

Plus particulièrement, lors de l'étape 40 de recouvrement par voie sèche du décor 3 et de la partie restante de la première couche 2 de protection métallique sacrificielle, par au moins une deuxième couche 4 de traitement décoratif métallique ou/et coloré, on effectue ce recouvrement par voie sèche avec une deuxième épaisseur comprise entre 50 nanomètres et 2000 nanomètres, plus particulièrement entre 50 nanomètres et 1000 nanomètres.

De préférence, lors de l'étape 20 de recouvrement par voie sèche de l'embase 1 par au moins une première couche 2 de protection métallique sacrificielle, on effectue le recouvrement avec une première épaisseur qui est supérieure ou égale à la différence entre, d'une part une deuxième épaisseur d'une deuxième couche 4 de traitement décoratif métallique ou/et coloré lors de l'étape 40 de recouvrement par voie sèche du décor 3 et de la partie restante de ladite première couche 2 de protection métallique sacrificielle, et d'autre part la profondeur de gravure dans le substrat de l'embase 1 lors de l'opération de gravure 30 d'un décor 3.

Dans une variante de réalisation avantageuse, lors de l'étape 30 de gravure d'un décor 3, avec une profondeur au moins égale à l'épaisseur locale de la première couche 2 de protection métallique sacrificielle, on effectue la gravure au moyen d'un laser pico ou femto.

En alternative de l'invention, on peut, selon un mode opératoire similaire, réaliser cette gravure par différents moyens, seuls ou en combinaison : laser, usinage à l'outil, bombardement ionique, attaque chimique, ou similaires.

Dans une variante particulière, lors de l'étape 30 de gravure d'un décor 3, avec une profondeur au moins égale à l'épaisseur locale de la première couche 2 de protection métallique sacrificielle, on effectue la gravure sous forme d'une juxtaposition de cuvettes coniques ou pyramidales profondes.

Plus particulièrement, on effectue cette gravure 30 avec une profondeur dans l'embase 1 comprise entre 20 nanomètres et l'épaisseur totale de l'embase 1.
On peut, ainsi, par exemple, creuser une cuvette conique très profonde sur toute l'épaisseur d'un cadran, par exemple sur une épaisseur de l'ordre du millimètre.

Plus particulièrement, pour d'autres applications, notamment d'affichage, on effectue une gravure laser, sensiblement plate, de 20 µm de profondeur environ.

Dans une autre variante, on effectue une gravure laser plus profonde, par exemple pour définir une cuvette, ou encore un guichet de date biseauté, ou similaire. L'invention permet la réalisation très fine d'un tel guichet biseauté bicolore, excessivement difficile à réaliser par d'autres moyens.

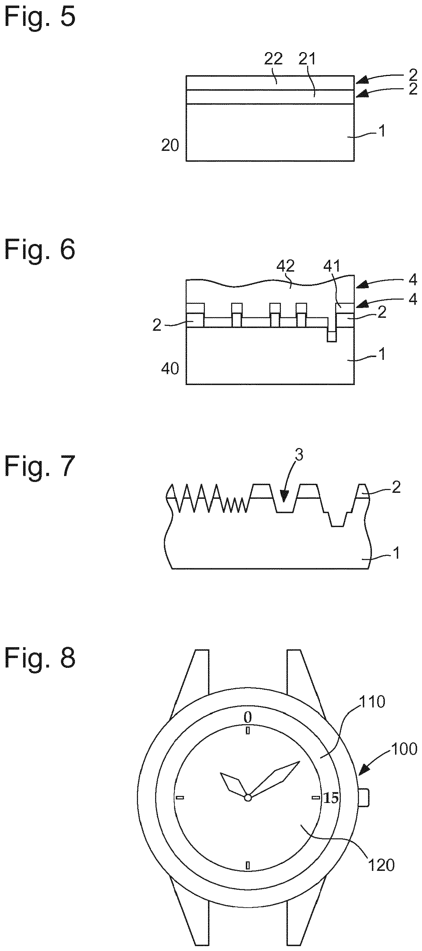

Dans une variante particulière, tel que visible sur la figure 5, lors de l'étape 20 de recouvrement par voie sèche de l'embase 1 par au moins une première couche 2 de protection métallique sacrificielle, on effectue le recouvrement par voie sèche avec superposition de plusieurs premières couches 2 de nature différente 21, 22.

Le choix des matériaux utilisable est assez large :
- pour le substrat non conducteur on peut utiliser en particulier: céramique, saphir, verre, verre organique, plastique, émail, matériau au moins partiellement amorphe :
- pour la protection métallique sacrificielle, par exemple de l'aluminium ou du chrome:
   ∘ pour une protection métallique sacrificielle comportant de l'aluminium, un traitement décoratif peut comporter : Au, Cr, Rh, Ti, Si, et/ou alliages et/ou oxydes et/ou nitrures et/ou carbures et/ou combinaisons de ces métaux ;
   ∘ pour une protection métallique sacrificielle comportant du chrome, un traitement décoratif peut comporter : Au, Rh, Ti, Si, et/ou alliages et/ou oxydes et/ou nitrures et/ou carbures et/ou combinaisons de ces métaux.

Dans une variante particulière, tel que visible sur la figure 6, lors de l'étape 40 de recouvrement par voie sèche du décor 3 et de la partie restante de ladite première couche 2 de protection métallique sacrificielle, par au moins une deuxième couche 4 de traitement décoratif métallique ou/et coloré, on effectue le recouvrement par voie sèche avec superposition de plusieurs deuxièmes couches 4 de nature différente, 41, 42.

Plus particulièrement, on effectue cette superposition de plusieurs deuxièmes couches 4 avec une couche de chrome de 50 à 250 nanomètres et une couche d'or de 50 à 150 nanomètres. Plus particulièrement on effectue le dépôt en superposition d'une couche de chrome épaisse d'environ 200 nanomètres, et d'une couche d'or épaisse d'environ 100 nanomètres.

L'invention se prête particulièrement bien au cas préféré où, lors de l'étape de réalisation 10 de l'embase 1, on utilise un substrat en céramique.

L'invention permet de réaliser des composants bicolores ou multicolores.

En effet, on peut effectuer une itération du procédé, avec des décors gravés différents, ou/et des traitements décoratifs différents.

Ainsi, après l'exécution de la phase 50 et achèvement d'un premier cycle élémentaire, et après un nettoyage, on peut exécuter au moins un autre cycle élémentaire avec des paramètres modifiés pour l'opération de gravure et/ou pour le choix du traitement décoratif.

Il est donc possible, sans limitation du nombre d'itérations, de recommencer, avec des paramètres modifiés, toute la séquence opératoire du cycle élémentaire avec :
- dépôt de protection métallique sacrificielle ;
- gravure d'un autre décor, par exemple ailleurs sur le substrat et/ou partiellement sur une gravure déjà réalisée dans une phase antérieure;
- dépôt d'un autre traitement décoratif ;
- dissolution de la protection métallique sacrificielle.

Ce cycle peut être refait plusieurs fois pour obtenir des composants multicolores, présentant par exemple des parties d'aspect différent en Au, Ti, Si, Rh, ou autres.

Une texture particulière de la gravure peut, aussi, permettre d'obtenir un aspect visuel particulier, selon la rugosité, la densité et la profondeur de gravure, qui déterminent des reflets ou un rendu particulier du traitement décoratif appliqué, par exemple satiné, semi-mat, brillant, ou autre.

L'invention concerne encore une montre 100, qui comporte un élément d'habillage 110, tel que lunette, boîte, ou similaire, notamment en céramique, ou/et qui comporte un cadran 120, notamment en céramique, réalisé par le procédé selon l'invention.

Ce mode opératoire permet de s'affranchir de l'utilisation d'équipements coûteux de photolithographie pour obtenir des décors de très bonne définition.

De plus, l'utilisation d'une couche de protection sacrificielle métallique permet d'éviter tout dégazage problématique lors du traitement sous vide préféré pour l'application de la couche de traitement décoratif métallique et/ou coloré.

L'invention se prête bien à la décoration de cadrans non conducteurs (céramique, émail, saphir, plastique, ou autre), de glaces (verre, saphir, ou autre), de composants en matière plastique, de boîtiers de montre, carrures, lunettes, couronnes, et autre. La qualité, la finesse et le contraste des décors, qui peuvent être réalisés en métaux précieux, autorisent une décoration de grande finesse compatible avec l'horlogerie de luxe, et notamment la décoration d'éléments de complications, comme par exemple des indicateurs de phase de lune à haute résolution. Le coût raisonnable de la mise en œuvre du procédé autorise aussi son utilisation pour des composants d'horlogerie de plus grande diffusion.

Naturellement, l'invention est avantageuse, non seulement pour des composants de composants d'horlogerie, mais aussi pour des bijoux ou des composants de bijouterie, voire de lunetterie ou d'articles de mode.

En effet, l'invention permet de modifier, et d'enrichir sensiblement l'aspect de composants directement visibles par l'utilisateur, avec des décors innovants, et participe à la promotion de la marque et du produit. Plus particulièrement, l'invention est utilisable pour des marquages d'identification et/ou des marquages anti-contrefaçon.

## Revendications

1. Procédé de fabrication d'un élément d'habillage ou d'un cadran d'horlogerie en matériau non conducteur, dans lequel on
effectue au moins une fois un
cycle élémentaire comportant, dans cet ordre, les étapes suivantes :
- (10) on réalise une embase (1) en un substrat en matériau non conducteur, ou en céramique ou en verre ou en saphir ou en matériau au moins partiellement amorphe,
- (20) on recouvre par voie sèche ladite embase (1) d'au moins une première couche (2) de protection métallique sacrificielle ;
- (30) on effectue la gravure d'un décor (3), avec une profondeur au moins égale à l'épaisseur locale de ladite première couche (2) de protection métallique sacrificielle, au moyen d'un laser à impulsion ultracourte type picolaser ou femtolaser ;
- (40) on recouvre par voie sèche ledit décor (3) et la partie restante de ladite première couche (2) de protection métallique sacrificielle, avec au moins une deuxième couche (4) de traitement décoratif métallique ou/et coloré ;
- (50) on élimine par voie chimique chaque dite première couche (2) de protection métallique sacrificielle,
et dans lequel, avant ou après l'élimination (50) par voie chimique de chaque dite première couche (2) de protection métallique sacrificielle, on arase mécaniquement (55) le composé ainsi réalisé au niveau supérieur de ladite embase (1).

2. Procédé selon la revendication 1, **caractérisé en ce que**, lors de ladite opération de gravure (30) d'un décor (3), on effectue partout ladite gravure dans ledit substrat de ladite embase (1).

3. Procédé selon la revendication 1 ou 2, **caractérisé en ce que**, lors de l'étape (20) de recouvrement par voie sèche de ladite embase (1) par au moins une première couche (2) de protection métallique sacrificielle, on effectue ledit recouvrement par voie sèche par dépôt PVD sous vide.

4. Procédé selon l'une des revendications 1 à 3, **caractérisé en ce que**, lors de l'étape (20) de recouvrement par voie sèche de ladite embase (1) par au moins une première couche (2) de protection métallique sacrificielle, on effectue ledit recouvrement avec une première épaisseur supérieure à 50 nanomètres.

5. Procédé selon l'une des revendications 1 à 4, **caractérisé en ce que**, lors de l'étape (40) de recouvrement par voie sèche dudit décor (3) et de ladite partie restante de ladite première couche (2) de protection métallique sacrificielle, par au moins une deuxième couche (4) de traitement décoratif métallique ou/et coloré, on effectue ledit recouvrement par voie sèche par dépôt PVD sous vide.

6. Procédé selon l'une des revendications 1 à 5, **caractérisé en ce que**, lors de l'étape (40) de recouvrement par voie sèche dudit décor (3) et de ladite partie restante de ladite première couche (2) de protection métallique sacrificielle, par au moins une deuxième couche (4) de traitement décoratif métallique ou/et coloré, on effectue ledit recouvrement par voie sèche avec une deuxième épaisseur comprise entre 50 nanomètres et 1'000 nanomètres.

7. Procédé selon l'une des revendications 1 à 6, **caractérisé en ce que**, lors de l'étape (20) de recouvrement par voie sèche de ladite embase (1) par au moins une première couche (2) de protection métallique sacrificielle, on effectue ledit recouvrement avec une première épaisseur qui est supérieure ou égale à la différence entre, d'une part une deuxième épaisseur d'une deuxième couche (4) de traitement décoratif métallique ou/et coloré lors de l'étape (40) de recouvrement par voie sèche dudit décor (3) et de ladite partie restante de ladite première couche (2) de protection métallique sacrificielle, et d'autre part la profondeur de gravure dans le substrat de ladite embase (1) lors de ladite opération de gravure (30) d'un décor (3).

8. Procédé selon l'une des revendications 1 à 7, **caractérisé en ce que**, lors de l'étape (30) de gravure d'un décor (3), avec une profondeur au moins égale à l'épaisseur locale de ladite première couche (2) de protection métallique sacrificielle, on effectue ladite gravure sous forme d'une juxtaposition de cuvettes coniques ou pyramidales profondes.

9. Procédé selon l'une des revendications 1 à 8, **caractérisé en ce qu'**on effectue ladite gravure (30) avec une profondeur dans ladite embase (1) comprise entre 20 nanomètres et l'épaisseur totale de ladite embase (1).

10. Procédé selon l'une des revendications 1 à 9, **caractérisé en ce que**, lors de l'étape (20) de recouvrement par voie sèche de ladite embase (1) par au moins une première couche (2) de protection métallique sacrificielle, on effectue ledit recouvrement par voie sèche avec superposition de plusieurs dites premières couches (2) de nature différente.

11. Procédé selon l'une des revendications 1 à 10, **caractérisé en ce que**, lors de l'étape (40) de recouvrement par voie sèche dudit décor (3) et de ladite partie restante de ladite première couche (2) de protection métallique sacrificielle, par au moins une deuxième couche (4) de traitement décoratif métallique ou/et coloré, on effectue ledit recouvrement par voie sèche avec superposition de plusieurs dites deuxièmes couches (4) de nature différente.

12. Procédé selon la revendication 11, **caractérisé en ce qu'**on effectue ladite superposition de plusieurs dites deuxièmes couches (4) avec une couche de chrome de 50 à 250 nanomètres et une couche d'or de 50 à 150 nanomètres.

13. Procédé selon l'une des revendications 1 à 12, **caractérisé en ce que**, lors de l'étape de réalisation (10) de ladite embase (1), on utilise un substrat en céramique.

14. Procédé selon l'une des revendications 1 à 13, **caractérisé en ce que**, après l'achèvement du premier dit cycle élémentaire et un nettoyage, on exécute au moins un autre dit cycle élémentaire avec des paramètres modifiés pour ladite opération de gravure et/ou pour le choix dudit traitement décoratif.

## Patentansprüche

1. Verfahren zur Herstellung eines Verkleidungselements oder eines Uhrenzifferblatts aus nichtleitendem Material, wobei mindestens einmal ein Grundzyklus durchgeführt wird, der die folgenden Schritte in dieser Reihenfolge umfasst:
- (10) Anfertigen einer Basis (1) aus einem Substrat aus nichtleitendem Material oder aus Keramik oder aus Glas oder aus Saphir oder aus mindestens teilweise amorphem Material,
- (20) Trockenbeschichten der Basis (1) mit mindestens einer ersten metallischen Opfer-Schutzschicht (2);
- (30) Ätzen eines Dekors (3) mit einer Tiefe von mindestens gleich der örtlichen Dicke der ersten metallischen Opfer-Schutzschicht (2) mittels eines Ultrakurzpulslasers vom Typ Picolaser oder Femtolaser;
- (40) Trockenbeschichten des Dekors (3) und des verbleibenden Teils der ersten metallischen Opfer-Schutzschicht (2) mit mindestens einer zweiten metallischen und/oder farbigen dekorativen Behandlungsschicht (4);
- (50) chemisches Abtragen jeder ersten metallischen Opfer-Schutzschicht (2),
und wobei vor oder nach dem chemischen Abtragen (50) jeder ersten metallischen Opfer-Schutzschicht (2) die so angefertigte Verbindung im oberen Bereich der Basis (1) mechanisch eingeebnet (55) wird.

2. Verfahren nach Anspruch 1, **dadurch gekennzeichnet, dass** beim Vorgang des Ätzens (30) eines Dekors (3) das Ätzen überall im Substrat der Basis (1) durchgeführt wird.

3. Verfahren nach Anspruch 1 oder 2, **dadurch gekennzeichnet, dass** beim Schritt (20) des Trockenbeschichtens der Basis (1) mit mindestens einer ersten metallischen Opfer-Schutzschicht (2) das Trockenbeschichten durch PVD-Abscheidung unter Vakuum durchgeführt wird.

4. Verfahren nach einem der Ansprüche 1 bis 3, **dadurch gekennzeichnet, dass** beim Schritt (20) des Trockenbeschichtens der Basis (1) mit mindestens einer ersten metallischen Opfer-Schutzschicht (2) die Beschichtung mit einer ersten Dicke von größer als 50 Nanometer durchgeführt wird.

5. Verfahren nach einem der Ansprüche 1 bis 4, **dadurch gekennzeichnet, dass** beim Schritt (40) des Trockenbeschichtens des Dekors (3) und des verbleibenden Teils der ersten metallischen Opfer-Schutzschicht (2) mit mindestens einer zweiten metallischen und/oder farbigen dekorativen Behandlungsschicht (4) die Trockenbeschichtung durch PVD-Abscheidung unter Vakuum durchgeführt wird.

6. Verfahren nach einem der Ansprüche 1 bis 5, **dadurch gekennzeichnet, dass** beim Schritt (40) des Trockenbeschichtens des Dekors (3) und des verbleibenden Teils der ersten metallischen Opfer-Schutzschicht (2) mit mindestens einer zweiten metallischen und/oder dekorativen farbigen Behandlungsschicht (4) die Trockenbeschichtung mit einer zweiten Dicke im Bereich zwischen 50 Nanometer und 1 000 Nanometer durchgeführt wird.

7. Verfahren nach einem der Ansprüche 1 bis 6, **dadurch gekennzeichnet, dass** beim Schritt (20) des Trockenbeschichtens der Basis (1) mit mindestens einer ersten metallischen Opfer-Schutzschicht (2) die Beschichtung mit einer ersten Dicke durchgeführt wird, die größer oder gleich der Differenz zwischen einerseits einer zweiten Dicke einer zweiten metallischen und/oder farbigen dekorativen Behandlungsschicht (4) beim Schritt (40) des Trockenbeschichtens des Dekors (3) und des verbleibenden Teils der ersten metallischen Opfer-Schutzschicht (2), und andererseits der Ätztiefe im Substrat der Basis (1) beim Vorgang des Ätzens (30) eines Dekors (3) ist.

8. Verfahren nach einem der Ansprüche 1 bis 7, **dadurch gekennzeichnet, dass** beim Schritt (30) des Ätzens eines Dekors (3) mit einer Tiefe von mindestens gleich der örtlichen Dicke der ersten metallischen Ofer-Schutzschicht (2) das Ätzen in Form einer Aneinanderreihung von tiefen kegelförmigen oder pyramidenförmigen Vertiefungen durchgeführt wird.

9. Verfahren nach einem der Ansprüche 1 bis 8, **dadurch gekennzeichnet, dass** das Ätzen (30) mit einer Tiefe in der Basis (1) im Bereich zwischen 20 Nanometer und der Gesamtdicke der Basis (1) durchgeführt wird.

10. Verfahren nach einem der Ansprüche 1 bis 9, **dadurch gekennzeichnet, dass** beim Schritt (20) des Trockenbeschichtens der Basis (1) mit mindestens einer ersten metallischen Opfer-Schutzschicht (2) die Trockenbeschichtung mit Überlagerung von mehreren ersten Schichten (2) unterschiedlicher Art durchgeführt wird.

11. Verfahren nach einem der Ansprüche 1 bis 10, **dadurch gekennzeichnet, dass** beim Schritt (40) des Trockenbeschichtens des Dekors (3) und des verbleibenden Teils der ersten metallischen Opfer-Schutzschicht (2) mit mindestens einer zweiten metallischen und/oder farbigen dekorativen Behandlungsschicht (4) die Trockenbeschichtung mit Überlagerung von mehreren zweiten Schichten (4) unterschiedlicher Art durchgeführt wird.

12. Verfahren nach Anspruch 11, **dadurch gekennzeichnet, dass** die Überlagerung mehrerer zweiter Schichten (4) mit einer Chromschicht von 50 bis 250 Nanometer und einer Goldschicht von 50 bis 150 Nanometer durchgeführt wird.

13. Verfahren nach einem der Ansprüche 1 bis 12, **dadurch gekennzeichnet, dass** beim Schritt des Anfertigens (10) der Basis (1) ein Substrat aus Keramik verwendet wird.

14. Verfahren nach einem der Ansprüche 1 bis 13, **dadurch gekennzeichnet, dass** nach dem Abschluss des ersten Grundzyklus und einer Reinigung mindestens ein weiterer Grundzyklus mit modifizierten Parametern beim Vorgang des Ätzens und/oder bei der Wahl der dekorativen Behandlung ausgeführt wird.

## Claims

1. Method for fabricating an external element or a timepiece dial made of non-conductive material, in which a basic cycle is performed at least once, including, in this order, the following steps:
- (10) making a base (1) from a substrate made of non-conductive material, or ceramic or glass or sapphire or at least partially amorphous material,
- (20) dry coating said base (1) with at least a first sacrificial protective metal layer (2);
- (30) etching a decoration (3), to a depth at least equal to the local thickness of said first sacrificial protective metal layer (2), by means of an ultrashort pulse laser of the femto laser or pico laser type;
- (40) coating said decoration (3) and the remaining part of said first sacrificial protective metal layer (2) with at least a second metal and/or coloured decorative treatment layer (4);
- (50) chemically removing each said first sacrificial protective metal layer (2),
and in which, before or after chemical removal (50) of each said first sacrificial protective metal layer (2), the compound thus formed (1) is mechanically levelled (55) on the upper level of said base (1).

2. Method according to claim 1, **characterized in that**, during said operation of etching (30) a decoration (3), said etch is performed over the entire said substrate of said base (1).

3. Method according to claim 1 or 2, **characterized in that**, during the step (20) of dry coating said base (1) with at least a first sacrificial protective metal layer (2), said dry coating is performed by vacuum PVD deposition.

4. Method according to any of claims 1 to 3, **characterized in that**, during the step (20) of dry coating said base (1) with at least a first sacrificial protective metal layer (2), said coating is made with a first thickness greater than 50 nanometres.

5. Method according to any of claims 1 to 4, **characterized in that**, during the step (40) of dry coating said decoration (3) and said remaining part of said first sacrificial protective metal layer (2) with at least a second metal and/or coloured decorative treatment layer (4), said dry coating is performed by vacuum PVD deposition.

6. Method according to any of claims 1 to 5, **characterized in that**, during the step (40) of dry coating said decoration (3) and said remaining part of said first sacrificial protective metal layer (2), with at least a second metal and/or coloured decorative treatment layer (4), said dry coating is made with a second thickness comprised between 50 nanometres and 1000 nanometres.

7. Method according to any of claims 1 to 6, **characterized in that**, during the step (20) of dry coating said base (1) with at least a first sacrificial protective metal layer (2), said coating is made with a first thickness which is greater than or equal to the difference between, on the one hand, a second thickness of a second metal and/or coloured decorative treatment layer (4) during the step (40) of dry coating said decoration (3) and the remaining part of said first sacrificial protective metal layer (2), and on the other hand, the etch depth in the substrate of said base (1) during said operation (30) of etching a decoration (3).

8. Method according to any of claims 1 to 7, **characterized in that**, during the step (30) of etching a decoration (3) to a depth at least equal to the local thickness of said first sacrificial protective metal layer (2), said etch is made in the form of a juxtaposition of deep conical or pyramidal recesses.

9. Method according to any of claims 1 to 8, **characterized in that** said etch (30) is made to a depth in said base (1) comprised between 20 nanometres and the total thickness of said base (1).

10. Method according to any of claims 1 to 9, **characterized in that**, during the step (20) of dry coating said base (1) with at least a first sacrificial protective metal layer (2), said dry coating is performed with a superposition of several said first layers (2) of different types.

11. Method according to any of claims 1 to 10, **characterized in that**, during the step (40) of dry coating said decoration (3) and said remaining part of said first sacrificial protective metal layer (2), with at least a second metal and/or coloured decorative treatment (4), said dry coating is performed with a superposition of several said second layers (4) of different types.

12. Method according to claim 11, **characterized in that** said superposition of several said second layers (4) is made with a chromium layer of 50 to 250 nanometres and a gold layer of 50 to 150 nanometres.

13. Method according to any of claims 1 to 12, **characterized in that**, during the step (10) of making said base (1), a ceramic substrate is used.

14. Method according to any of claims 1 to 13, **characterized in that**, following completion of a first said basic cycle and a cleaning operation, at least one more said basic cycle is performed with modified parameters for said etching operation and/or for the choice of said decorative treatment.
